# EUROPÄISCHE PATENTSCHRIFT

(11) **EP 1 557 677 B1**
(45) Veröffentlichungstag und Bekanntmachung des Hinweises auf die Patenterteilung: **08.08.2007**
(21) Anmeldenummer: 04030810.8
(22) Anmeldetag: 27.12.2004
(51) Int. Cl.: G01R 11/04, G01R 11/24

(54) **Stromzähleranordnung**
Electricity meter assembly
Assemblage avec compteur d'électricité

(30) Priorität: 20.01.2004 DE 102004003050; 09.06.2004 DE 102004028223
(43) Veröffentlichungstag der Anmeldung: 27.07.2005
(73) Patentinhaber: ABB PATENT GmbH, 68526 Ladenburg (DE)
(72) Erfinder: Eppe, Klaus-Peter, Dipl.-Ing., 69429 Waldbrunn (DE); Wieland, Ralf, Dipl.-Ing. (FH), 69429 Waldbrunn (DE)
(74) Vertreter: Miller, Toivo

(56) Entgegenhaltungen:
- DE-A1- 10 052 998
- DE-A1- 10 054 771
- DE-A1- 10 111 584
- DE-U1- 20 301 607
- DE-U1- 20 313 421
- DE-U1-4202004 001 83

## Beschreibung

Die Erfindung betrifft eine Stromzähleranordnung gemäß dem Oberbegriff des Anspruches 1.

Durch die DE 103 44 736.9 ist eine Stromzählereinrichtung der eingangs genannten Art vorgeschlagen worden, bei der ein Stromzähler auf einen Adapter aufsetzbar und in diesen montierbar ist, welcher Adapter in einem Zählerplatz untergebracht ist. Zur Montage wird der Stromzähler senkrecht zur Befestigungsebene auf den Adapter aufgesetzt, wobei die am Stromzäher angebrachten Anschlussfahnen ins Innere des Adapters eingeführt sind; dabei greifen die Anschlussfahnen in Aussparungen an Überbrückungselementen ein, die die feststehenden Kontaktstücke im Inneren des Adapters, die jeweils in einem Phasenleitungszug liegen, überbrücken. Bei Verschieben des Stromzählers in Richtung der Befestigungsebene nehmen die Anschlussfahnen die Überbrückungselemente mit, so dass diese von den Kontaktstücken freikommen, während die Anschlussfahnen des Stromzählers mit den feststehenden Kontaktstücken eine elektrisch leitende Verbindung erreichen. Für die Demontage ist der Vorgang umgekehrt: Beim Verschieben des Stromzählers nehmen die Anschlussfahnen das Überbrückungselement mit, und in der Stellung, in der der Stromzähler entfernt werden kann, überbrücken die Überbrückungselemente die Kontaktstücke, so dass sowohl bei der Montage als auch bei der Demontage, insbesondere bei der Demontage, der Stromfluss zu den Verbrauchern nicht unterbrochen wird.

Bei dieser Ausgestaltung muss der Stromzähler zunächst in seine Ausgangslage am Adapter und danach durch eine Verschiebung senkrecht dazu in seine Endlage gebracht werden.

Die DE 100 52 998 A1 zeigt eine alternative Ausführungsform einer Aufnahmeplattform für eine Stromzählereinheit mit Einrichtungen für die Bildung einer Überbrückung zwischen ihren Anschlusskontakten bei Abkoppelung der Stromzählereinheit von der Plattform. Die Stromzählereinheit wird dabei mit ihrer Befestigungsfläche auf die Aufnahmeplattform aufgesetzt und parallel zur Befestigungsfläche in Richtung ihrer Endposition verschoben.

Die DE 203 13 421 U1 zeigt eine Plombiereinrichtung für einen steck- und verschiebbar auf einer Zählertragplatte angeordneten Elektrizitätszähler, wobei ein in den Elektrizitätszähler eingesteckter und formschlüssig gehaltener Plombierriegel in der Funktionsstellung des Elektrizitätszählers diesen gegen Verschieben sichert.

Aufgaben der Erfindung ist es, eine Stromzähleranordnung der eingangs genannten Art zu schaffen, bei der die Montage weiter vereinfacht wird.

Diese Aufgabe wird erfindungsgemäß gelöst durch die Merkmale des Anspruchs 1. Erfindungsgemäß also umfasst der Aufnahmeadapter für den Stromzähler wenigstens ein Führungsmittel für den Stromzähler, welches wenigstens eine Schrägfläche aufweist, auf der der Stromzähler nach dem Aufsetzen auf das Führungsmittel in seine Endstellung gleitet.

Hierbei wird ausgenutzt, dass an der Befestigungsfläche senkrecht dazu angeordnete L-förmige Füße vorgesehen sind, deren freie Schenkel in gleiche Richtung vorspringen. Gemäß einer weiteren Ausführungsform der Führungsmittel ist am Adapter je eine Schrägfläche für jeden Fuß vorgesehen, auf die beim Einsetzen des Stromzählers die Füße aufstehen und auf der sie und damit der Stromzähler in ihre Endstellung gleiten.

Bei der bekannten Ausführung könnte es sein, dass der Stromzähler beim Aufsetzen nicht in seine korrekte Stellung (Vormontagestellung) gelangt ist, so dass das Verschieben zumindest behindert wird; bei der erfindungsgemäßen Anordnung setzen sich die Füße auf die Schrägfläche auf und der Stromzähler befindet sich dann in seiner korrekten Vormontagestellung. Um in seine Endstellung zu gelangen, wird der Stromzähler auf der Schrägfläche verschoben, so dass die Anschlussfahnen in die feststehenden Kontaktstücke im Adapter eingleiten können.

Gemäß einer besonders vorteilhaften Ausgestaltung besitzt die Schrägfläche wenigstens zwei Abschnitte, von denen ein erster Abschnitt den Stromzähler derart führt, dass seine Anschlussfahnen in den Bereich der feststehenden Kontaktstücke am Adapter gelangen, ohne mit diesen in elektrisch leitende Verbindung zu kommen, und von denen der zweite Abschnitt, der steiler ist als der erste Abschnitt, so bemessen ist, dass die Anschlussfahnen in die feststehenden Kontaktstücke beim weiteren Verschieben abgesenkt werden.

Da bei dem Durchlaufen des ersten Abschnittes ein Einsenken der Anschlussfahnen in die Kontaktstücke verhindert werden soll, bildet der erste Abschnitt mit der Befestigungsebene einen Winkel zwischen 5° bis 10°. Damit die Anschlussfahnen in die Kontaktstücke gelangen, ist der zweite Abschnitt steiler und nimmt mit der Befestigungsebene einen Winkel zwischen 20° bis 40° ein, vorzugsweise 30°. Beide Winkel sind abhängig von der Länge der Anschlussfahnen, der Länge der feststehenden Kontaktstücke, senkrecht zur Bodenfläche des Adapters gemessen, und der Höhe des Adapters, ebenfalls senkrecht zur Befestigungsfläche gemessen.

Die Schrägfläche kann auch gekrümmt sein, und zwar in besonders vorteilhafter Weise S-förmig, wobei der erste Abschnitt mit seiner konvexen Seite zum Stromzähler und der zweite Abschnitt mit seiner konkaven Seite zum Stromzähler hin gerichtet ist. Dadurch wird die Montage eines Stromzählers mit einer weicheren Bewegung erfolgen.

Andererseits ist die Herstellung der Schrägfläche mit den beiden geraden Abschnitten gemäß Anspruch 4 einfacher herzustellen.

Weitere vorteilhafte Ausgestaltungen und Verbesserungen der Erfindung sind den abhängigen Ansprüchen zu entnehmen.

Anhand der Zeichnungen, in der Ausführungsbeispiele der Erfindung dargestellt sind, sollen die Erfindung sowie weitere vorteilhafte Ausgestaltungen und Verbesserungen und weitere Vorteile näher erläutert und beschrieben werden.

### Es zeigen

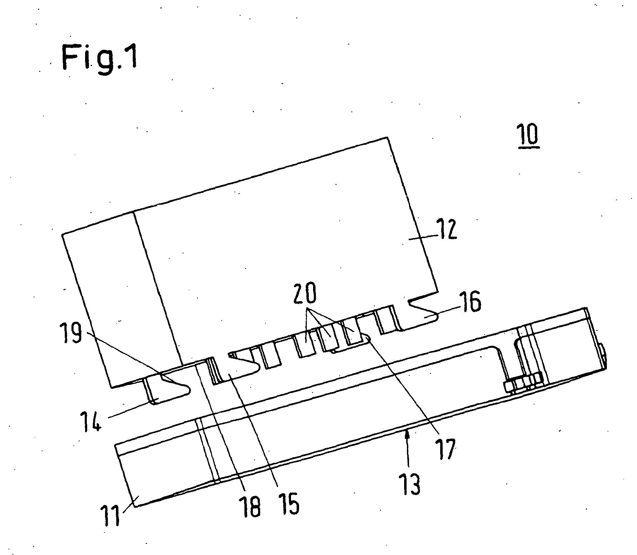

- Fig. 1: eine perspektivische Ansicht eines Adapters und eines Stromzählers, vor der Montage,
- Fig. 2: eine perspektivische Ansicht der Anordnung nach Fig. 1, im Vormontagezustand, wobei die dem Betrachter zugewandte Schmalseitenfläche zum besseren Einblick weggelassen ist,
- Fig. 3: die Anordnung gemäß Fig. 2 in vergrößerter Teildarstellung,

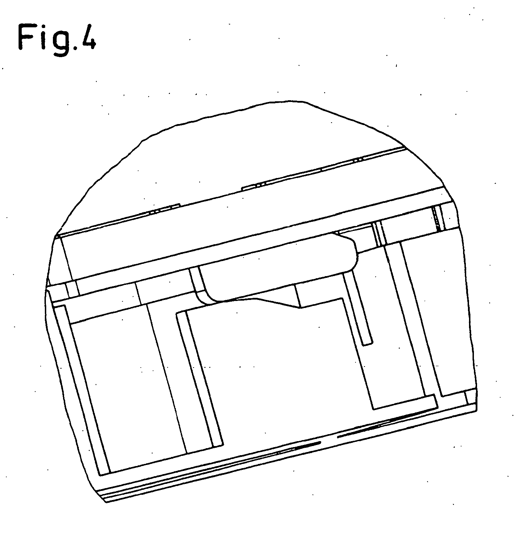

- Fig. 4: eine weitere Vergrößerung der Ausgestaltung gemäß Fig. 3,
- Fig. 5: die Anordnung gemäß den Figuren 1 bis 4 in einer zweiten Stellung,
- Fig. 6 bis 8: unterschiedliche Schrägflächen,
- Fig. 9: eine Seitenansicht auf eine Anschlussfahne und ein zugehöriges feststehendes Kontaktstück,
- Fig. 10: eine Ansicht gemäß Pfeilrichtung X der Fig. 9, und
- Fig. 11: die Seitenansicht einer weiteren Ausgestaltung eines Fußes, und

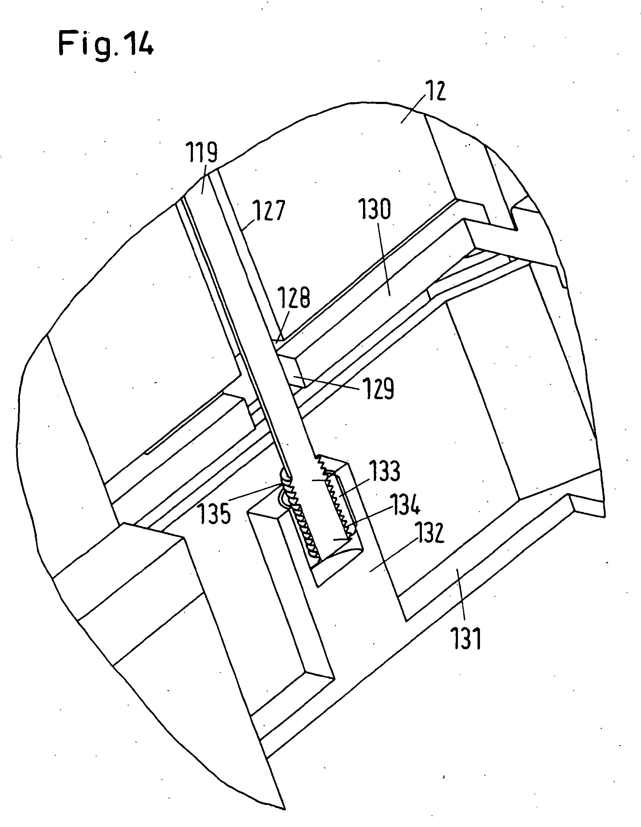

- Fig. 12 bis 14: eine Verriegelung mittels einer Plombierstange.

Eine erfindungsgemäße Stromzähleranordnung 10 besitzt einen Adapter 11, der etwa so ausgebildet ist wie der Adapter gemäß der eingangs genannten deutschen Patentanmeldung DE 103 44 736.9, wobei gegenüber diesem Adapter einige Änderungen vorgenommen sind, die die erfindungsgemäße Lösung beinhalten. Auf den Adapter 11 wird ein Stromzähler 12 montiert. Die Unterseite 13 des Adapters 11, die sich auf der dem Stromzähler 12 entgegengesetzten Seite des Adapters 11 befindet, wird in einer Installationsverteilung auf ein Zählerkreuz aufgesetzt und dort befestigt.

Im Inneren des Adapters befinden sich, wie weiter unten näher erläutert werden wird, feststehende Kontaktstücke sowie Überbrückungselemente.

Auf der Befestigungsseite des Stromzählers 12 sind vier L-förmige Füße 14, 15, 16 und 17 angeformt, deren freie Schenkel in gleiche Richtung vorspringen. Die der Befestigungsfläche 18 zugewandten Kanten 19 der L-Form sind abgeschrägt (die Bezugsziffer 19 ist der Übersichtlichkeit halber lediglich dem Fuß 14 zugeordnet; selbstverständlich besitzen die anderen Füße 15 bis 17 die gleiche schräg verlaufende Innenkante).

Auf der Befestigungsseite 18 ragen Anschlussfahnen 20 hervor, die paarweise einander zugeordnet sind und an denen im Inneren des Stromzählers 12 entsprechende Stromsensoren, mit denen der verbrauchte Strom gemessen wird, zugeordnet sind. Im eingebauten Zustand fließt demgemäss der Strom über Stromzuführungsanschlüsse, im Inneren des Adapters befindliche feststehende Kontaktstücke über die Anschlussfahnen 20 durch den Stromzähler 12 hindurch und von dort über die zugehörigen Anschlussfahnen dann zu den Stromabführungsanschlüsse.

Die Ausgestaltung der Stromzu- bzw. Abführungsanschlüsse sowie der feststehenden Kontaktstücke im Inneren des Adapters ist ebenfalls der DE 103 44 736.9 zu entnehmen.

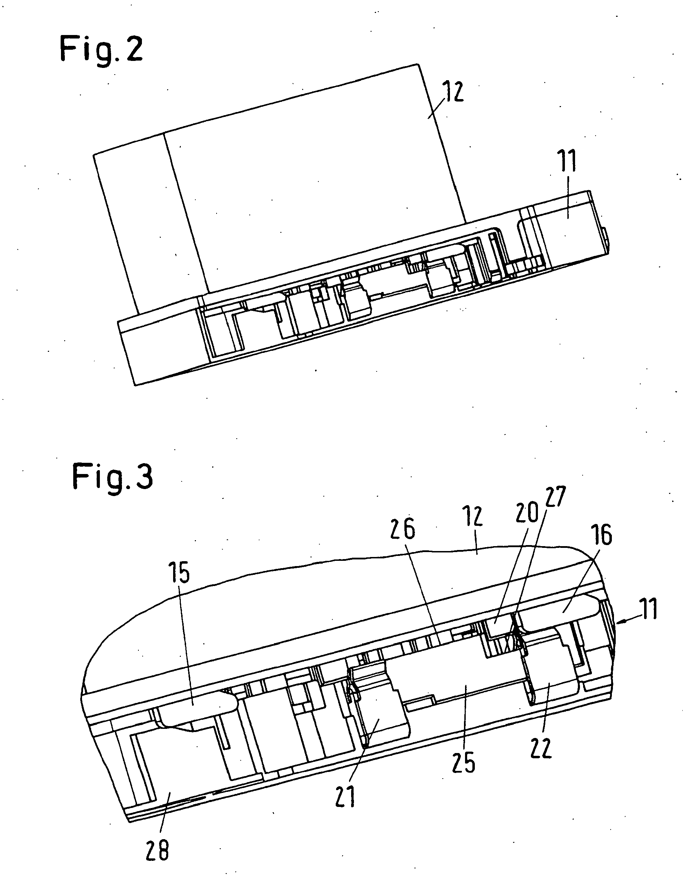

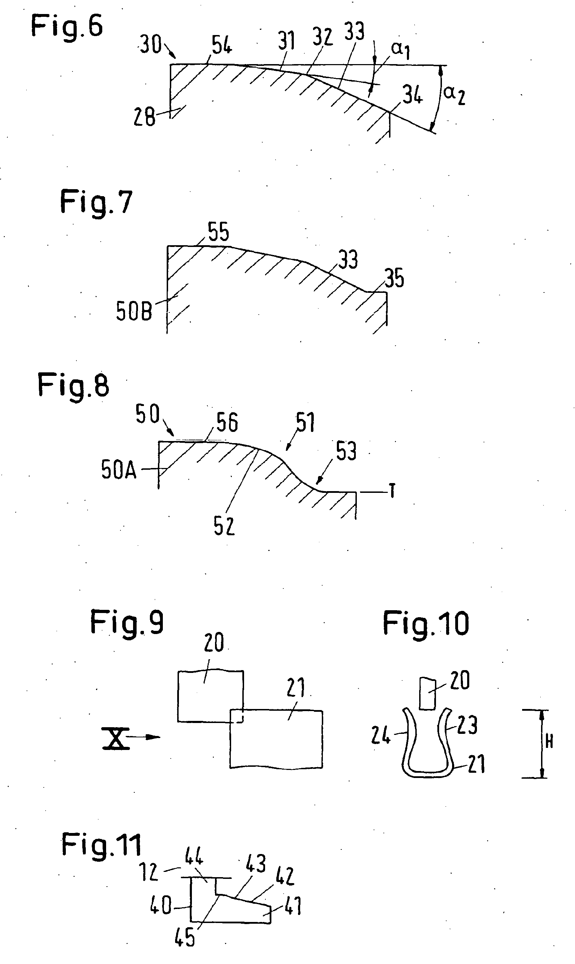

Es sei nun Bezug genommen auf die Fig. 2.
Der Stromzähler 12 ist in den Adapter 11 eingesetzt. Man erkennt insbesondere aus der Fig. 3 zwei in einer Phase liegende feststehende Kontaktstücke 21 und 22, die hier als U-förmige Kontakttulpen ausgebildet sind (siehe auch Fig. 10), deren Schenkel 23 und 24 senkrecht zur Befestigungsfläche des Stromzählers 12 am Adapter 11 bzw. des Adapters 11 am Zählerkreuz (nicht gezeigt) verlaufen.

Zwischen den feststehenden Kontaktstücken 21 und 22 befindet sich ein Überbrückurigselement 25, das als Flachbandleiter ausgebildet ist, wobei dessen Breitseite senkrecht zur Befestigungsfläche verläuft. An seiner zum Stromzähler 12 hinweisenden Längskante 26 besitzt das Überbrückungselement 25 eine Aussparung 27, in die eine der Anschlussfahnen 20 beim Einsetzen des Stromzählers auf den Adapter wenigstens teilweise eingreift.

Innerhalb des Adapters 11 sind die Füße 15 und 16 zu erkennen, wobei der Fuß 15 auf einem an der Bodenseite des Adapters 11 aufstehenden bzw. senkrecht dazu angeformten Sockel 28 aufliegt. Der Stromzähler 12 besitzt vier Füße 14 bis 17; demgemäss sind auch im Adapter vier Sockel 28 vorgesehen, so dass alle vier Füße auf den zugehörigen Sockeln aufstehen. Der dem Fuß 16 dargestellte Sockel ist zur Verdeutlichung weggelassen; die anderen Sockel sind - ebenso wie die Füße 14 und 17 - in der Ansicht gemäß Fig. 3 nicht sichtbar.

Die Fig. 6 zeigt eine erste Ausführungsform eines Sockels 28.

Dessen Stirnkante 30 besitzt einen ersten Abschnitt 31, der gegenüber der Befestigungsfläche um einen Winkel α₁ geneigt ist; dieser Winkel α₁ ist so bemessen, dass die Anschlussfahne 20 gerade in den Bereich der Kontakttulpe 21 gelangt, aber mit der Kontakttulpe 21 bzw. mit den Schenkeln 24 und 23 noch nicht in Kontakt gelangt ist. Sobald der Fuß 15 über den Knickpunkt 32 hinweggleitet, gelangt er in einen zweiten Abschnitt 33, der mit der Befestigungsfläche einen Winkel α₂ bildet; sobald der Fuß auf dieser Schrägfläche abgleitet, gelangt die Anschlussfahne 20 in Kontakt mit den Schenkeln 23 und 24; während des Abgleitens über die den Abschnitt 31 greift, wie in Fig. 3 dargestellt, die Anschlussfahne 20 teilweise in die Aussparung 27 ein, so dass das Überbrückungselement von der Anschlussfahne 20 mitgenommen wird. Bei weiterem Abgleiten des Fußes 15 auf dem Abschnitt 33 und Erreichen einer bestimmten Stellung berührt die Anschlussfahne 20 die Kontakttulpe 21 und das Überbrückungselement ist ebenfalls noch mit den beiden Kontakttulpen 21 und 22 in Berührung. Sobald der Fuß 15 den Endpunkt 34 der Schrägfläche 30 erreicht hat, befindet sich der Stromzähler in seiner Endmontagestellung; das Überbrückungselement 25 hat dann die Kontakttulpe 21 verlassen und die Aussparung 27 befindet sich im Bereich der Kontakttulpe 22, so dass eine elektrisch leitende Verbindung zwischen den Kontakttulpen 21 und 22 und dem Überbrückungselement nicht mehr gegeben ist. Der Strom fließt nun vollständig über den Strommesser. In einer Zwischenstellung fließt der Strom sowohl über den Strommesser als auch über das Überbrückungselement; dadurch wird beim Montieren und umgekehrt beim Demontieren eine unterbrechungsfreie Stromversorgung gewährleistet.

Die Winkel α₁ und α₂ sind entsprechend der Höhe H der Kontakttulpe zu bemessen; erforderlich ist, dass der oben beschriebene Verlauf erreicht wird. Dies hängt ab von der Höhe H der Kontakttulpe und den Abmessungen der Anschlussfahnen sowie des Adapters 11.

Bei der Ausführung gemäß Fig. 7 schließt sich an den Abschnitt 33 ein dritter Abschnitt 35 an, auf den der Fuß 15 gleiten kann; dieser Abschnitt 35 ist vorgesehen insbesondere zur Erzielung einer Kontaktreinigung zwischen den Anschlussfahnen und der Kontakttulpe. Lediglich ergänzend wird dieser Bereich noch zu einer gewissen Verriegelung dienen, insbesondere dann, wenn der Fuß 15 so ausgebildet ist wie in Fig. 11 dargestellt: der am Stromzähler 12 angebrachte Fuß 40 besitzt einen Schenkel 41 dessen zum Stromzähler weisende Innenkante 42 eine Abschrägung 43 und direkt an den Steg 44 anschließend einen weiteren Abschnitt 45 aufweist, der parallel zur Befestigungsebene verläuft.

Die Fig. 8 zeigt eine weitere Ausführungsform eines Sockels; die Stirnkante 50 besitzt als Schrägfläche 51 einen ersten Abschnitt 52, dessen konvexe Seite zum Stromzähler, und einen steileren Abschnitt 53, dessen konvexe Seite zum Stromzähler hin gerichtet ist. Der Abschnitt 53 endet dabei in einer Tangente T, die parallel zur Befestigungsfläche des Stromzählers 12 verläuft.

Die Sockel 28 und 50A besitzen weiterhin einen vierten Abschnitt 54, 55 und 56, der parallel zur Befestigungsfläche verläuft und auf den der Fuß nach Einsetzen senkrecht zur Befestigungsebene zum Aufliegen kommt, wodurch eine eindeutige Vormontageposition definiert ist.

Wenn der Sockel 28 gemäß Fig. 6 verwendet wird, ist ein Absatz 45 der Innenkante 42 nicht erforderlich.

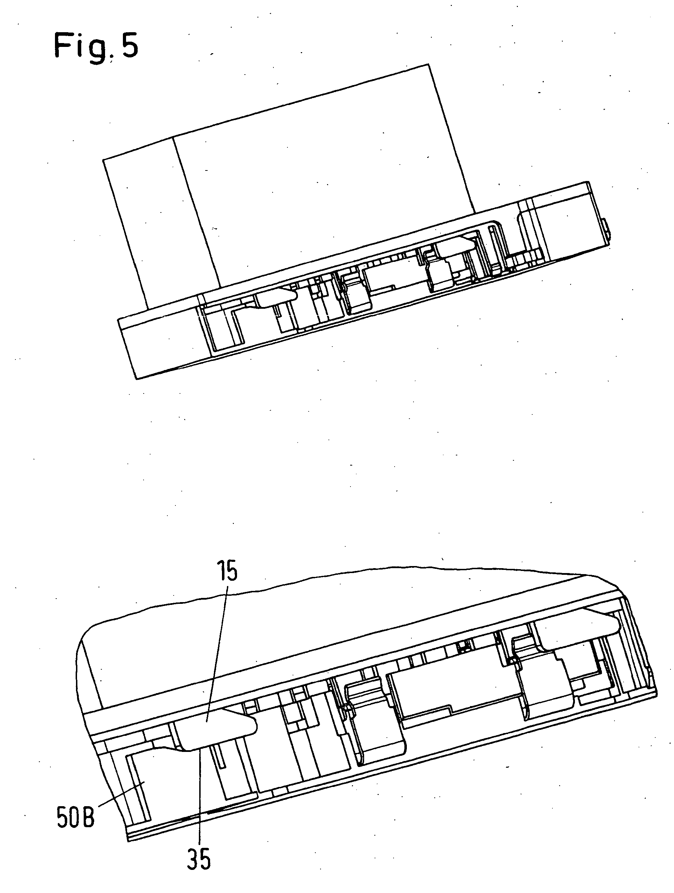

Die Fig. 5 zeigt eine Ausführung eines Sockels 50B, bei dem der dritte Abschnitt 35 verlängert ist; der Fuß 15 sitzt dann auf diesem Abschnitt 35.

Der Stromzäher 12 weist an seiner Frontseite 113, an der ein Anzeigenfenster 114 vorgesehen ist, eine rechteckige Vertiefung 115 auf, die in einer senkrecht dazu verlaufende Seitenfläche 116 einmündet. Aus der Bodenfläche 117 der Vertiefung 115 ragt der Kopf 118 einer Plombierstange 119 (siehe Fig. 11) heraus, der an seiner Stirnfläche einen Schlitz 120 und darunter quer dazu eine Durchgangsbohrung 121 aufweist, durch die ein Plombierungsdraht (nicht dargestellt) hindurch gefädelt werden kann, wobei am Stromzähler 12 eine mit einer Durchgangsöffnung 122 versehene Lasche 123 vorgesehen ist; die Plombierung erfolgt dann dadurch, dass durch die Durchgangsbohrung 121 und die Öffnung 122 der Plombierdraht hindurch gesteckt werden kann. Der Schlitz 120 ist für den Eingriff eines Werkzeuges zum Verdrehen der Plombierstange 119 vorgesehen.

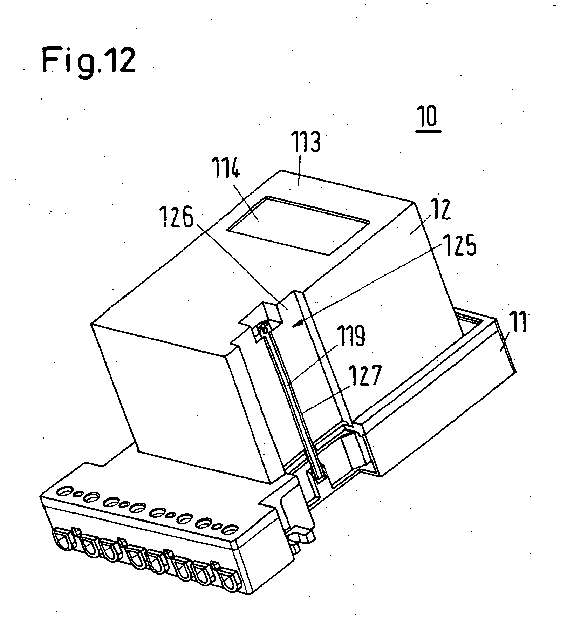

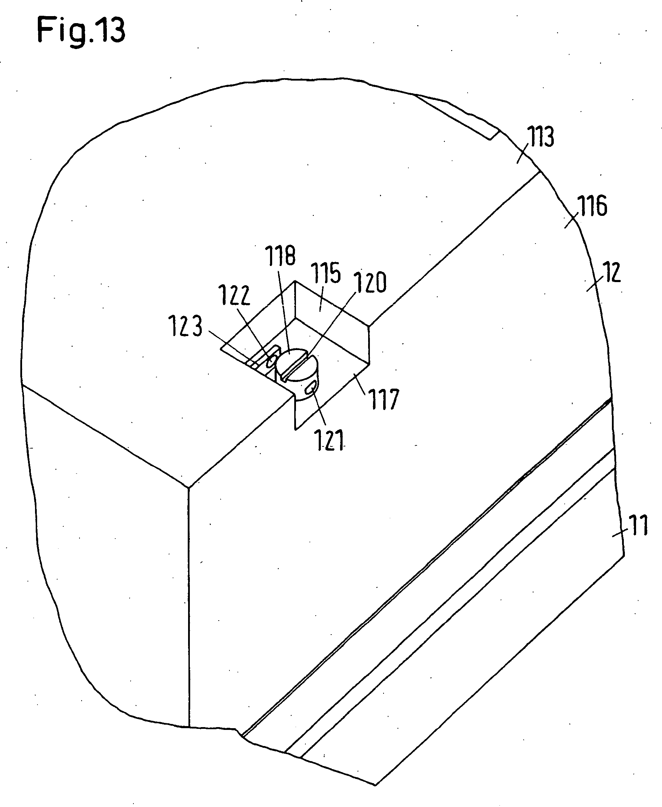

Die Fig. 12 zeigt einen Vertiefungsschnitt 125, wodurch eine fiktive Ebene 126 gebildet ist, die genau durch die Mittelachse der Plombierstange 119 hindurch verläuft und die zeigt, dass die Plombierstange 119 eine Durchgangsöffnung 127 im Stromzähler 12 durchgreift. Die Fig. 13 zeigt dies teilweise in vergrößerter Darstellung.

Die Plombierstange 119 durchgreift dabei auch einen Durchbruch 128 im Boden des Stromzählers 12 und eine Durchbrechung 129 in der dem Stromzähler 12 zugewandten Abdeckplatte 130 des Adapters 11. An der Bodenseite 131 des Adapters 11 ist ein zum Stromzähler 12 hin vorspringender Pfosten 132 angeformt, in den eine Hülse 133 mit einem Innengewinde 134 eingepresst bzw. eingegossen ist. In das Innengewinde 134 wird dann ein Außengewinde 135 an dem dem Kopf 118 entgegengesetzten Ende der Plombierstange 119 eingeschraubt.

Mit dem Einschrauben der Plombierstange 119 in die Hülse 133, die aus Metall hergestellt sein kann, wird der Stromzähler 12 mit dem Adapter 11 fest verbunden, so dass gleichzeitig mit der Plombierung auch die Verriegelung des Stromzählers 12 am Adapter erzielt ist.

Das Innengewinde kann natürlich auch in geeigneter Weise an der Abdeckplatte 130 fixiert sein.

## Patentansprüche

1. Stromzähleranordnung (10) mit einem eine Befestigungsfläche (18) aufweisenden Stromzähler (12), und einem an einem Zählerplatz in einer elektrischen Installationsverteilung anbringbaren Aufnahmeadapter (11) für den Stromzähler (12), welcher wenigstens ein Führungsmittel (28) für den Stromzähler (12) umfasst, und mit innerhalb des Adapters (11) angeordneten feststehenden Kontaktstücken, die im montierten Zustand mit Anschlusselementen am Stromzähler (12) in elektrisch leitender Verbindung stehen, und mit Überbrückungselementen (25), die, gesteuert von dem Stromzähler (12) die feststehenden Kontaktstücke kurz schließt, wenn der Stromzähler (12) demontiert ist, **dadurch gekennzeichnet, dass** das Führungsmittel (28) wenigstens eine Schrägfläche (31,33, 51) aufweist, auf der der Stromzähler (12) nach dem Aufsetzen auf das Führungsmittel (28) in seine Endstellung gleitet.

2. Stromzähleranordnung (10) nach Anspruch 1, mit an der Befestigungsfläche (18) senkrecht dazu angeordneten L-förmigen Füßen (14, 15,16, 17,40) deren freie Schenkel (41) in die gleiche Richtung vorspringen, und mit einer der Anzahl der L-förmigen Füße entsprechenden Anzahl von Führungsmitteln (28), wobei beim Einsetzen des Stromzählers (12) die Füße (14, 15,16, 17,40) auf die Führungsmittel (28) aufsetzen und wobei beim Verschieben des Stromzählers die Füße auf den Schrägflächen (31, 33, 51) der Führungsmittel (28) in seine Endstellung gleiten.

3. Stromzähleranordnung (10) nach Anspruch 1 oder 2, **dadurch gekennzeichnet, dass** die Schrägfläche wenigstens zwei Abschnitte (31,33, 35,54, 55,56, 53,52) aufweist, von denen ein erster Abschnitt (31,52) den Stromzähler (12) derart führt, dass seine Anschlussfahnen (20) in den Bereich der feststehenden Kontaktstücke (21, 22) am Adapter (11) gelangen, ohne mit diesen in elektrisch leitende Verbindung zu kommen, und von der ein zweiter, steilerer Abschnitt (33,53) so bemessen ist, dass die Anschlussfahnen (20) in die feststehenden Kontaktstücke (21,22) beim weiteren Abgleiten abgesenkt werden.

4. Stromzähleranordnung (10) nach Anspruch 3, **dadurch gekennzeichnet, dass** der erste Abschnitt (31, 52) zur Befestigungsebene (18) um einen Winkel zwischen 5° bis 10° und der zweite Abschnitt um einen Winkel zwischen 20° bis 40° geneigt sind.

5. Stromzähleranordnung (10) nach Anspruch 3, **dadurch gekennzeichnet, dass** die Schrägfläche (51) gekrümmt ist.

6. Stromzähleranordnung (10) nach Anspruch 5, **dadurch gekennzeichnet, dass** die Schrägfläche (12) S-förmig verläuft, mit einem ersten Abschnitt (52), dessen konvexe Seite zum Stromzähler (12) hin, und mit einem zweiten, steileren Abschnitt (53), dessen konkave Seite zum Stromzähler (12) hin gerichtet sind, wobei der zweite Abschnitt (53) an seinem Ende in eine Tangentiale ausläuft, die parallel zur Befestigungsebene (18) verläuft.

7. Stromzähleranordnung (10) nach einem der vorherigen Ansprüche, wobei an der Befestigungsfläche (18) wenigstens ein L- förmiger Fuß (14,15, 16,17, 40) angebracht ist, der einen Steg 44 und einen freien Schenkel (41) mit einer zur Befestigungsfläche hin weisenden inneren Kante (19, 42) mit wenigstens einem Kantenabschnitt aufweist, **dadurch gekennzeichnet, dass** die der Befestigungsfläche (18) zugewandte innere Kante (19, 42) jedes freien Schenkels (41) zu seinem freien Ende hin abgeschrägt ist, wobei der Winkel zwischen der inneren Kante (19,42) und der Befestigungsfläche (18) etwa dem Winkel des zweiten Abschnittes (33,53) der Schrägfläche mit der Befestigungsfläche (18) entspricht.

8. Stromzähleranordnung (10) nach einem der vorherigen Ansprüche, **dadurch gekennzeichnet, dass** die innere Kante (19,42) des freien Schenkels (41) des L-förmigen Fußes (14,15, 16,17, 40)anschließend an den Steg (44) der L-Form einen parallel zur Befestigungsfläche (18) verlaufenden ersten Kantenabschnitt (45) aufweist.

9. Stromzähleranordnung (10) nach einem der vorherigen Ansprüche, **dadurch gekennzeichnet, dass** an den zweiten Abschnitt der Schrägfläche (33) ein dem parallel zur Befestigungsfläche (18) verlaufenden ersten Kantenabschnitt (45) der inneren Kante (19,42) des freien Schenkels (41) des L- förmigen Fußes (14,15, 16,17, 40) entsprechender dritter Abschnitt (35) anschließt, der parallel zur Befestigungsfläche (18) verläuft.

10. Stromzähleranordnung (10) nach einem der vorherigen Ansprüche, mit einer eine Plombierschraube aufweisenden Plombiereinrichtung, **dadurch gekennzeichnet, dass** die Plombiereinrichtung zur Verriegelung des Stromzählers (12) am Adapter (11) dient.

11. Stromzähleranordnung (10) nach Anspruch 10, **dadurch gekennzeichnet, dass** im Adapter (11) eine Hülse mit Innengewinde vorgesehen ist, in das die mit einem Anschlussgewinde versehene Plombierschraube einschraubbar ist.

## Claims

1. An electricity meter arrangement (10), comprising a meter (12) having a fastening surface (18) and a receiving adapter (11) for the meter (12), which adapter can be attached to a meter position in an electric installation distribution and which comprises at least one guide means (28) for the meter (12), and fixed contact elements arranged within the adapter (11), which in the mounted state are in electrically conductive connection with connection elements on the meter (12), and bridging elements (25) which short-circuits the fixed contact elements under control by the meter (12) when the meter (12) is dismounted, **characterized in that** the guide means (28) comprises at least one inclined surface (31, 33, 51) on which the meter (12) slides to its end position after the placement on the guide means (28).

2. An electricity meter arrangement (10) according to claim 1, comprising L-shaped feet (14, 15, 16, 17, 40) which are arranged perpendicular thereto on the fastening surface (18) and whose free legs (41) protrude in the same direction, and a number of guide means (28) corresponding to the number of the L-shaped feet, with the feet (14, 15, 16, 17, 40) being placed on the guide means (28) during the insertion of the meter (12) and with the feet, during the displacement of the meter, sliding to its end position on the inclined surfaces (31, 33, 51) of the guide means (28).

3. An electricity meter arrangement (10) according to claim 1 or 2, **characterized in that** the inclined surface comprises at least two sections (31, 33, 35, 54, 55, 56, 53, 52), of which a first section (31, 52) guides the meter (12) in such a way that its terminal lugs (20) reach the area of the fixed contact elements (21, 22) on the adapter without coming into an electrically conductive connection with the same, and of which a second, steeper section (33, 53) is dimensioned in such a way that the terminal lugs (20) can be lowered into the fixed contact elements (21, 22) during the further downward sliding.

4. An electricity meter arrangement (10) according to claim 3, **characterized in that** the first section (31, 52) is inclined relative to the fastening plane (18) by an angle of between 5° and 10° and the second section by an angle of between 20° to 40°.

5. An electricity meter arrangement (10) according to claim 3, **characterized in that** the inclined surface (51) is curved.

6. An electricity meter arrangement (10) according to claim 5, **characterized in that** the inclined surface (12) extends in an S-shaped manner, with a first section (52) whose convex side faces towards the meter (12) and with a second steeper section (53) whose concave side faces towards the meter (12), with the second section (53) trails out at its end into a tangent extending parallel to the fastening plane (18).

7. An electricity meter arrangement (10) according to one of the preceding claims, with at least one L-shaped foot (14, 15, 16, 17, 40) being attached to the fastening surface (18), which foot comprises a web (44) and a free leg (41) with an inner edge (19, 42) with at least one edge section facing towards the fastening surface, **characterized in that** the inner edge (19, 42) of each free leg (41) facing towards the fastening surface (18) is beveled towards its free end, with the angle between the inner edge (19, 42) and the fastening surface (18) corresponding approximately to the angle of the second section (33, 53) of the inclined surfaces with the fastening surface (18).

8. An electricity meter arrangement (10) according to one of the preceding claims, **characterized in that** the inner edge (19, 42) of the free leg (41) of the L-shaped foot (14, 15, 16, 17, 40) comprises a first edge section (45) extending parallel to the fastening surface (18) adjacent to the web (44) of the L-shape.

9. An electricity meter arrangement (10) according to one of the preceding claims, **characterized in that** a third section (35) which corresponds to the first edge section (45) of the inner edge (19, 42) of the free leg (41) of the L-shaped foot (14, 15, 16, 17, 40) extending parallel to the fastening surface (18) is adjacent to the second section of the inclined surface (33), which third section extends parallel to the fastening surface (18).

10. An electricity meter arrangement (10) according to one of the preceding claims, comprising a lead sealing device with a leading screw, **characterized in that** the lead sealing device is used for locking the meter (12) to the adapter (11).

11. An electricity meter arrangement (10) according to claim 10, **characterized in that** the adapter (11) comprises a sleeve with an inner thread into which the leading screw can be screwed which is provided with a connection lead.

## Revendications

1. Dispositif de compteur électrique (10) avec un compteur électrique (12) possédant une surface de fixation (18) et un adaptateur de montage (11) pour le compteur électrique (12) pouvant être mis en place à un emplacement de compteur dans un panneau de distribution d'installation électrique, qui comprend au moins un moyen de guidage (28) pour le compteur électrique (12), et avec des éléments de contact fixes disposés à l'intérieur de l'adaptateur (11), qui sont en contact conducteur d'électricité avec des éléments de raccordement du compteur électrique (12) dans l'état monté, et avec des éléments de pontage (25) qui court-circuitent, sous la commande du compteur électrique (12), les éléments de contact fixes, lorsque le compteur électrique (12) est démonté, **caractérisé en ce que** le moyen de guidage (28) comporte au moins une surface oblique (31, 33, 51) sur laquelle le compteur électrique (12) glisse dans sa position finale après avoir été posé sur le moyen de guidage (28).

2. Dispositif de compteur électrique (10) selon la revendication 1, avec des pieds en forme de L (14, 15, 16, 17, 40) disposés sur la surface de fixation (18) et perpendiculairement à celle-ci, dont les bras libres (41) dépassent dans la même direction, et avec un nombre de moyens de guidage (28) correspondant au nombre de pieds en forme de L, dans lequel, lors de l'insertion du compteur électrique (12), les pieds (14, 15, 16, 17, 40) reposent sur les moyens de guidage (28) et dans lequel, lors de la translation du compteur électrique, les pieds glissent sur les surfaces obliques (31, 33, 51) des moyens de guidage (28) vers sa position finale.

3. Dispositif de compteur électrique (10) selon la revendication 1 ou 2, **caractérisé en ce que** la surface oblique possède au moins deux parties (31, 33, 35, 54, 55, 56, 53, 52) dont une première partie (31, 52) guide le compteur électrique (12) de telle manière que ses cosses de connexion (20) parviennent au niveau des éléments de contact fixes (21, 22) sur l'adaptateur (11), sans venir en contact conducteur d'électricité avec ceux-ci, et dont une deuxième partie (33, 53), plus fortement inclinée, est dimensionnée de telle sorte que les cosses de connexion (20) soient abaissées dans les éléments de contact fixes (21, 22) lorsque le glissement se poursuit.

4. Dispositif de compteur électrique (10) selon la revendication 3, **caractérisé en ce que** la première partie (31, 52) est inclinée par rapport au plan de fixation (18) selon un angle compris entre 5° et 10° et la deuxième partie selon un angle compris entre 20° et 40°.

5. Dispositif de compteur électrique (10) selon la revendication 3, **caractérisé en ce que** la surface oblique (51) est courbe.

6. Dispositif de compteur électrique (10) selon la revendication 5, **caractérisé en ce que** la surface oblique (12) est en forme de S, avec une première partie (52) dont le côté convexe est tourné vers le compteur électrique (12) et avec une deuxième partie (53), plus fortement inclinée, dont le côté concave est tourné vers le compteur électrique (12), la deuxième partie (53) s'achevant à son extrémité par une tangente parallèle au plan de fixation (18).

7. Dispositif de compteur électrique (10) selon l'une des revendications précédentes, dans lequel il est prévu sur la surface de fixation (18) au moins un pied en forme de L (14, 15, 16, 17, 40) qui possède une barrette (44) et un bras libre (41) avec un bord intérieur (19, 42) orienté vers la surface de fixation avec au moins une partie d'arête, **caractérisé en ce que** le bord intérieur (19, 42) tourné vers la surface de fixation (18) de chaque bras libre (41) est biseauté vers son extrémité libre, l'angle entre le bord intérieur (19, 42) et la surface de fixation (18) correspondant approximativement à l'angle entre la deuxième partie (33, 53) de la surface oblique et la surface de fixation (18).

8. Dispositif de compteur électrique (10) selon l'une des revendications précédentes, **caractérisé en ce que** le bord intérieur (19, 42) du bras libre (41) du pied en forme de L (14, 15, 16, 17, 40) présente après la barrette (44) de la forme en L une première partie d'arête (45) parallèle à la surface de fixation (18).

9. Dispositif de compteur électrique (10) selon l'une des revendications précédentes, **caractérisé en ce que** la deuxième partie de la surface oblique (33) est suivie d'une troisième partie (35) correspondant à la première partie d'arête (45) parallèle à la surface de fixation (18) du bord intérieur (19, 42) du bras libre (41) du pied en forme de L (14, 15, 16, 17, 40) et orientée parallèlement à la surface de fixation (18).

10. Dispositif de compteur électrique (10) selon l'une des revendications précédentes, avec un dispositif de plombage comportant une vis de plombage, **caractérisé en ce que** le dispositif de plombage sert à verrouiller le compteur électrique (12) sur l'adaptateur (11).

11. Dispositif de compteur électrique (10) selon la revendication 10, **caractérisé en ce qu'**il est prévu dans l'adaptateur (11) une douille dans laquelle la vis de plombage pourvue d'un filetage de raccordement peut être vissée.
